# EUROPÄISCHE PATENTSCHRIFT

(11) **EP 0 801 143 B1**
(45) Veröffentlichungstag und Bekanntmachung des Hinweises auf die Patenterteilung: **07.05.2003**
(21) Anmeldenummer: 97101697.7
(22) Anmeldetag: 04.02.1997
(51) Int. Cl.: C23C 14/04, C23C 14/34, H01J 37/34

(54) **Vorrichtung zum Maskieren oder Abdecken von Substraten**
Apparatus for masking or covering of substrates
Appareil de recouvrement ou masquage de substrats

(30) Priorität: 13.04.1996 DE 19614600
(43) Veröffentlichungstag der Anmeldung: 15.10.1997
(73) Patentinhaber: Singulus Technologies AG, 63755 Alzenau (DE)
(72) Erfinder: Kempf, Stefan, 63755 Alzenau-Albstadt (DE)
(74) Vertreter: Heunemann, Dieter, Dr.

(56) Entgegenhaltungen:
- DE-A- 4 315 023
- GB-A- 2 286 201

## Beschreibung

Die Erfindung bezieht sich auf eine Vorrichtung zum Maskieren oder Abdecken von Substraten für eine Zerstäubungskathode mit einem Mittelmaskenführungsteil, an dem eine das Substrat abdeckende Mittelmaske angeordnet ist, die mit einer Außenmaske derart zusammenwirkt, daß beim Beschichtungsvorgang nur der nicht abgedeckte Teil des Substrats beschichtet wird.

Es ist bereits eine Vorrichtung zur Kathodenzerstäubung für scheibenförmige Substrate der eingangs aufgeführten Art bekannt (DE 43 15 023 Al), die mittels eines Plasmas in einer Vakuum- bzw. Prozeßkammer mit mindestens einer Öffnung versehen ist, welche durch Auflegen einer Zerstäubungskathode von außen verschließbar ist, wobei zwischen der Kathode und einer Kammerwand ein elastischer Dichtring vorgesehen ist. Mit dieser Vorrichtung läßt sich eine CD am Innen- und Außendurchmesser maskieren, so daß nur bestimmte Oberflächenteile der CD beschichtet werden. Mittels dieser Vorrichtung sollen bestimmte definierte Oberflächenbereiche der CD so beschichtet werden, daß eine scharfe Abgrenzung der beschichteten Oberflächenbereiche gegenüber den nicht beschichteten bzw. metallisierten Oberflächenbereichen der CD erreicht wird. Hierzu wird die CD am Außen- und Innenrand der Innen- und Außenmaske angedrückt. Das gleichzeitige Andrücken an zwei verschiedenen Bauteilen ist aufgrund von Höhendifferenzen aufwendig und schwierig und erfordert sehr kleine Herstellungstoleranzen.

Die GB-A-2286 201 beschreibt eine Kathodenzerstäubungsvorrichtung für scheibenförmige Substrate mit einer Mittelmaske und einer davon unabhängigen Außenmaske. Eine Vestellung der beiden Masken gegeneinorder ist nicht vorgesehen.

Demgemäß besteht die Erfindungsaufgabe darin, eine Vorrichtung zu schaffen, mittels der bestimmte definierte Oberflächenbereiche der CD so beschichtet werden, daß eine scharfe Abgrenzung der beschichteten Oberflächenbereiche gegenüber den nicht beschichteten bzw. metallisierten Oberflächenbereichen der CD erreicht wird, wobei das Substrat bzw. die CD derart verstellt wird, daß Höhendifferenzen ohne weiteres ausgeglichen werden können.

Gelöst wird die Aufgabe erfindungsgemäß dadurch, daß die Mittel- und/oder die Außenmaske unabhängig voneinander verstellbar sind. Da die Innen- und Außenmaske der Zerstäubungskathode gegenüber dem Substrat unabhängig verstellbar sind, lassen sie sich mit einem gleichmäßigen Anpreßdruck gegen die Oberfläche des Substrats pressen, so daß eine exakte und definierte Oberfläche gebildet wird, die mittels der Kathode nicht beschichtet wird. Durch den gleichmäßigen Anpreßdruck der beiden Masken wird erreicht, daß kein Schichtmaterial unterhalb der Maske bzw. in den Zwischenraum zwischen der Unterseite der Maske und der Oberfläche des Substrats bzw. der CD gelangt.

Auf diese Weise können auch Fertigungstoleranzen weitgehend ausgeglichen werden, so daß die beiden Masken, selbst bei unterschiedlich langen Masken, in der Endlagestellung, d. h. wenn sie gegen die Oberfläche des Substrats anliegen, auf einer gleichen Querebene liegen.

Ferner ist es vorteilhaft, daß die Mittelmaske unabhängig von der Außenmaske in Abhängigkeit des Gasdrucks in der Vorrichtung zum Beschichten des Substrats verstellbar ist. Durch den Einsatz des Gasdrucks, der in der Vorrichtung besteht, läßt sich die Mittelmaske in Richtung des Substrats verstellen, so daß das Substrat zwangsweise zum Verstellen der Mittelmaske immer dann genutzt wird, wenn das Substrat in Richtung der Masken bewegt wird. Durch Einzelverstellen der Mittelmaske kann das Substrat auch zuerst in Richtung der Oberfläche des Substrats bewegt werden, bzw. die Mittelmaske kann mit Bezug auf die Außenmaske in eine Stellung gebracht werden, in der die Mittelmaske mit Bezug auf die Außenmaske etwas hervorsteht. Dadurch wird sichergestellt, daß zuerst die Mittelmaske gegen die Oberfläche des Substrats zur Anlage kommt, die dann bei Verstellen des Substrats in Richtung der Mittelmaske anschließend auch gegen die Außenmaske zur Anlage kommt, so daß dann beide Masken eine exakt definierbare Oberfläche schaffen, die zur Beschichtung freigegeben ist.

Eine zusätzliche Möglichkeit ist gemäß einer Weiterbildung der erfindungsgemäßen Vorrichtung, daß die Mittelmaske unabhängig von der Außenmaske in Abhängigkeit eines Differenzdrucks in der Vorrichtung in Richtung des Substrats und/oder in Richtung der Längsmittelachse der Vorrichtung bzw. der Kathode verstellbar ist. Der Differenzdruck kann auf kostengünstige Weise zum Verstellen der Mittelmaske in Richtung der Oberfläche eingesetzt werden, so daß auf zusätzliche Stellorgane verzichtet werden kann. Hierdurch wird sichergestellt, daß die Mittelmaske stets zuerst gegen die Oberfläche des Substrats zur Anlage kommt. Wird das Substrat weiter nach oben verstellt bzw. in Richtung der beiden Masken, so kommt anschließend der äußere Rand des Substrats gegen die Außenmaske zur Anlage. Hierdurch wird ein gleichmäßiger Anpreßdruck beider Masken gegen die Oberfläche des Substrats erreicht.

In weiterer Ausgestaltung der Erfindung ist es vorteilhaft, daß die Differenzdruckkraft F_{dif} in der Vorrichtung durch den Außendurchmesser des verstellbaren Teils der Halterung, die koaxial zur Längsmittelachse der Kathode angeordnet ist, bestimmt wird.

Gemäß einer bevorzugten Ausführungsform der erfindungsgemäßen Lösung ist schließlich vorgesehen, daß der Differenzdruck-Durchmesser P_{d} sich im Bereich einer Membrane befindet bzw. durch den Durchmesser der Membrane bestimmt wird, die die Vakuumkammer der Vorrichtung gegenüber dem Raum abdichtet, in dem Atmosphärendruck herrscht, und daß die Mittelmaske aus einem tellerförmigen Maskenteil besteht, der an einem zylinderförmigen Kühlgehäuse angeordnet ist, das an dem Mittelmaskenführungsteil bzw. an einem Auslegerarm angeordnet und mit diesem gegenüber dem Differenzdruck verstellbar ist.

Von besonderer Bedeutung ist für die vorliegende Erfindung, daß der tellerförmige Maskenteil abhängig oder unabhängig vom Stellweg des Auslegers zwischen zwei verstellbaren Anschlägen verstellbar ist. Durch das unabhängige Verstellen des tellerförmigen, mittleren Maskenteils gegenüber dem äußeren Maskenteil läßt sich der Differenzdruck als Stellvorrichtung für den mittleren Maskenteil einsetzen, so daß auf gesonderte Stellorgane zum Verstellen des mittleren Maskenteils und zur Sicherstellung eines gleichmäßigen Anpreßdrucks beider Maskenteile verzichtet werden kann.

Außerdem ist es vorteilhaft, daß der tellerförmige Maskenteil lösbar mit dem zylinderförmigen Gehäuse bzw. Kühlgehäuse verbunden, zur Längsmittelachse konzentrisch angeordnet und koaxial am Kühlgehäuse lösbar angeschlossen ist.

Hierzu ist es vorteilhaft, daß das Kühlgehäuse am Mittelmaskenführungsteil lösbar angeschlossen und in seiner Stellbewegung durch mindestens einen Anschlag begrenzbar ist. Durch die verstellbar ausgebildeten Anschläge wird der Hubweg der Mittelmaske begrenzt und somit eine Beschädigung der Membrane verhindert.

Eine zusätzliche Möglichkeit ist gemäß einer Weiterbildung der erfindungsgemäßen Vorrichtung, daß der Mittelmaskenführungsteil zwischen zwei Anschlägen verstellbar ist und die Anschläge einstellbar sind.

In weiterer Ausgestaltung der Erfindung ist es vorteilhaft, daß die Anschläge an dem Mittelmaskenführungsteil bzw. an einem den Mittelmaskenführungsteil aufnehmenden Auslegerarm angeordnet sind und die Membrane, das Kühlgehäuse und/oder die Mittelmaske den den Atmosphärendruck Pₐ aufweisenden Raum gegenüber dem den Vakuumdruck aufweisenden Raum bzw. der Vakuumkammer abdichten.

Auf diese Weise wird erreicht, daß die Membrane aus einem zylinderförmigen Teil bzw. Mittelstück besteht, an das endseitig je ein Flansch angeschlossen ist, der in je einer Klemmvorrichtung derart lösbar aufgenommen ist, daß die Mittelmaske gegenüber der Klemmvorrichtung bzw. gegenüber den nicht verstellbaren Teilen der Vorrichtung bzw. der Außenmaske verstellbar ist, und daß die Mittelmaske mit Bezug auf die Außenmaske in der Anfangsstellung, in der die Masken mit Abstand zur Oberfläche des Substrats angeordnet sind, gegenüber der Oberfläche der Außenmaske derart hervorsteht, daß die Mittelmaske erst gegen die Oberfläche des Substrats zur Anlage kommt, wenn es in Richtung der Mittelmaske bewegt wird.

Von Vorteil ist es ferner, daß die Außenmaske und/oder der untere Teil der Mittelmaske lösbar angeschlossen sind und die Außenmaske und/oder der untere Teil der Mittelmaske mit annähernd gleichem Anpreßdruck gegen die Oberfläche des Substrats zur Anlage kommen.

Vorteilhaft ist es außerdem, daß der Mittelmaskenführungsteil, der Auslegerarm bzw. der den Mittelmaskenführungsteil führende bzw. verstellende Teil in einem ständig Atmosphärendruck Pₐ aufweisenden Raum vorgesehen sind.

Weitere Vorteile und Einzelheiten der Erfindung sind in den Patentansprüchen und in der Beschreibung erläutert sowie in der Zeichnung dargestellt, wobei bemerkt wird, daß alle Einzelmerkmale und alle Kombinationen von Einzelmerkmalen erfindungswesentlich sind. Es zeigt:

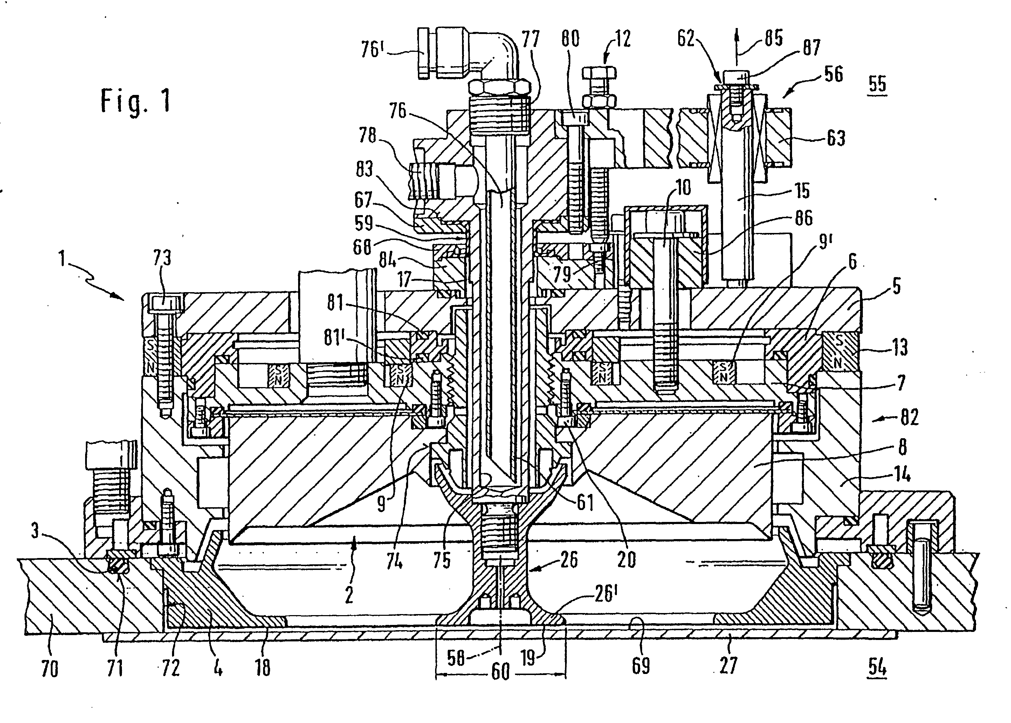

- Fig. 1: eine Schnittdarstellung einer Zerstäubungskathode mit einer einzeln verstellbaren Mittelmaske,

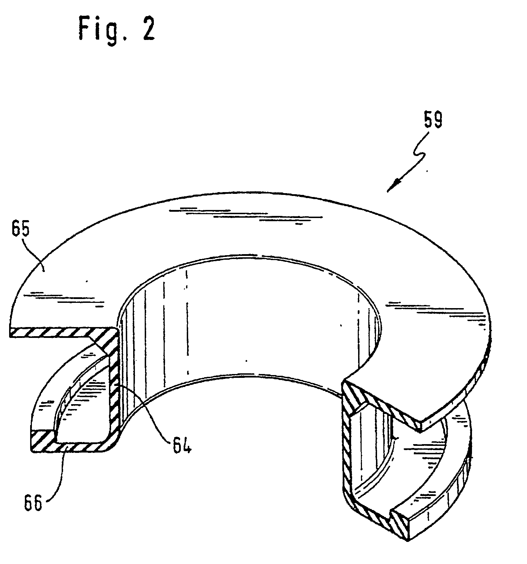

- Fig. 2: eine Membrane für die Mittelmaske.

In der Zeichnung ist mit 1 eine Vorrichtung zum Beschichten von Substraten bzw. CD's dargestellt, zu der eine Zerstäubungskathode 2 gehört.

Die Zerstäubungskathode 2 ist auf eine gemäß der Zeichnung ortsfeste Kammerwand 70 aufgesetzt. In der Kammerwand 70 befindet sich eine ringförmige Nut 71 zur Aufnahme einer Vakuumdichtung 3. Die Kammerwand 70 weist eine kreisförmige Öffnung 72 auf, in die sich eine Außenmaske 4 und eine Mittelmaske 26 erstrecken können.

Die Zerstäubungskathode 2 besteht aus einem scheibenförmigen, ferromagnetischen Joch 5 und einer Kühlplatte 7. Zwischen dem Joch 5 und der Kühlplatte 7 ist ein scheibenförmiger Isolator 6 eingesetzt. Das Joch 5 sowie die Kühlplatte 7 werden von einem Polschuh 82 umgeben, der über Schraubenbolzen 73 mit dem Joch 5 lösbar verbunden ist.

Mit Bezug auf die Zeichnung befindet sich unterhalb der Kühlplatte 7 ein zu zerstäubendes Target 8, das in einen Ringraum des Polschuhs 82 eingesetzt ist und mittels eines Schraubelements bzw. einer Hohlschraube 20 in der Kühlplatte 7 mittelbar gesichert ist.

Auf der Rückseite der Kühlplatte 7 ist ebenfalls eine ringförmige Nut für einen Ringmagneten 9 bzw. 9' vorgesehen. Das Joch 5, der Isolator 6 und die Kühlplatte 7 werden durch eine Schraube 10 zusammengehalten, wobei die Schraube 10 gegenüber dem Joch 5 durch einen Isolator 86 isoliert ist und mittels eines in der Zeichnung nicht dargestellten Kabels mit einer nicht gezeigten Sputterstrom-Versorgungseinrichtung verbunden ist.

Im Bereich der äußeren, radial verlaufenden Stirnfläche des Jochs 5 befindet sich ein Ringmagnet 13 mit dem zugehörigen Polschuh 14.

Wie aus der Zeichnung ferner hervorgeht, ist im inneren Bereich der Kathode 2 eine Axialbohrung 74 vorgesehen, die sich von der Rückseite des Jochs 5 bis zur Vorderseite des Targets 8 erstreckt. In dieser Axialbohrung 74 befindet sich eine Mittelmaske 26 (Mittelanode) mit einem sich daran anschließenden Kühlgehäuse 61, das hohlförmig ausgebildet ist und in seiner mittleren Bohrung eine Kühlleitung 76 aufweist, die mit einem Anschlußstutzen 76' versehen ist. Über den Anschlußstutzen 76' und die in der Bohrung 74 vorgesehene Leitung 76 kann das Kühlwasser eintreten und dann über die Bohrung 75 und eine Auslaßöffnung 78 nach außen abgeführt werden.

Das Kühlgehäuse 61, das sich durch die Bohrung 74 erstreckt, ist im oberen Bereich über Schraubenbolzen 77 mit einem Auslegerarm 63 verbunden und kann über diesen in Richtung einer Längsmittelachse 58 verstellt werden.

Ein einen Atmosphärendruck Pₐ aufweisender Raum 55 ist gegenüber einer Vakuumkammer 54 abgedichtet. Hierzu dienen u. a. das zylinderförmige Kühlgehäuse 61 und die Membrane 59, die aus einem zylinderförmigen Teil bzw. Mittelstück 64 bestehen, an das endseitig je ein Flansch 65, 66 fest angeschlossen ist. Die Flansche 65 und 66 erstrecken sich rechtwinklig zum Mittelstück 64 und sind mittels einer Klemmvorrichtung 67 und 68 gesichert. Die obere Klemmvorrichtung 67 liegt gegen eine Stirnfläche 83 des Auslegerarms 63 und der untere Flansch 66 gegen eine Halterung 84 an, die mit dem Joch über eine Schraube 87 verbunden ist. Die Klemmvorrichtung 68 ist hierzu über Schraubenbolzen 79 mit der Halterung 84 verbunden. Die obere Klemmvorrichtung 67 ist über Schraubenbolzen 80 mit dem Auslegerarm 63 verbunden. Hierdurch wird der obere Raum 55 gegenüber der Vakuumkammer 54 abgedichtet. Weitere Abdichtelemente 81, 81' befinden sich in entsprechenden, in der Zerstäubungskathode 2 vorgesehenen Ringnuten.

Der Auslegerarm 63 ist mittels einer feststehenden Drehsäule 15 auf dem Joch 5 mittelbar angeordnet und kann in Pfeilrichtung 85 nach oben bzw. nach unten verstellt werden. Der Stellweg des Auslegerarms 63 und auch die an dem Auslegerarm 63 mittelbar angeschlossene Mittelmaske 26 ist zwischen einem oberen Anschlag 62 und dem unteren Anschlag 12 verstellbar. Der obere Anschlag 62 besteht aus einer in die Drehsäule 15 eindrehbaren Schraube mit einem Anschlagteller. Der untere Anschlag 12 ist ebenfalls aus einer Einstellschraube mit einer Kontermutter gebildet, die sich durch den Auslegerarm 63 erstreckt und gegen die obere Seite der Halterung 84 zur Anlage kommt. Der Stellweg der Mittelmaske 26 und des zugehörigen Kühlgehäuses 61 sowie des Auslegerarms 63 wird also durch die beiden Anschläge 62 und 12 begrenzt und liegt im Bereich der Längsdehnung der Membrane 59, so daß eine Beschädigung der Membrane 59 durch die beiden Anschläge ausgeschlossen wird.

Herrscht im oberen Raum Atmosphärendruck Pₐ und in der Vakuumkammer ein Unterdruck bzw. ein geringerer Druck als der Druck Pₐ, so entsteht eine Differenzdruckkraft F_{dif} (vgl. 64), die durch eine Ringfläche 17 bestimmt wird, der sich aus dem Außendurchmesser des Kühlgehäuses 61 gemäß Zeichnung ergibt. Die Differenzdruckkraft F_{dif} bewirkt also ein Verstellen der Mittelmaske 26 in Richtung der Oberfläche eines Substrats 27. Der Stellweg der Mittelmaske 26 ist so gewählt, daß die Mittelmaske 26 mit Bezug auf die Außenmaske 4 in der Anfangsstellung, in der die Masken mit Abstand zu einer Oberfläche 69 des Substrats 27 angeordnet sind, gegenüber der Oberfläche oder Stirnfläche der Außenmaske 4 derart hervorsteht, daß die Stimfläche 19 den Mittelmaske 26 erst gegen die Oberfläche 69 des Substrats 27 zur Anlage kommt, wenn das Substrat 27 in Richtung der Mittelachse 58 bewegt wird. Dabei wirkt das Substrat 27 gegen den Stelldruck bzw. die Differenzdruckkraft F_{dif} und verstellt dabei die Mittelmaske 26 nach oben, bis der Randbereich der CD bzw. des Substrats 27 gegen eine Stirnfläche 18 der Außenmaske 4 zur Anlage kommt. Durch die vorteilhafte Anordnung der Außenmaske 4 und der Mittelmaske 26 wird bei einer Hubbewegung des Substrats 27 nach oben bei beiden Masken ein annähernd gleicher Anpreßdruck und somit ein definierter Abdeckbereich an der Oberfläche des Substrats 27 erzeugt, der nicht beschichtbar ist.

Obwohl es in der Zeichnung nicht dargestellt ist, besteht auch die Möglichkeit, auf ähnliche Weise die Außenmaske verstellbar auszubilden.

Im Ausführungsbeispiel ist die Mittelmaske 26 hierzu aus einem tellerförmigen Maskenteil 60 gebildet, der an dem zylinderförmigen Kühlgehäuse 61 lösbar angeordnet ist, das an einem Mittelmaskenführungsteil 56, zu dem der Auslegerarm 63 gehört, angeordnet ist.

Wie aus der Zeichnung hervorgeht, kann der tellerförmige Maskenteil 60 bzw. ein unterer Teil 26' lösbar mit dem zylinderförmigen Gehäuse bzw. dem Kühlgehäuse 61 verbunden sein, damit der tellerförmige Maskenteil 60, wenn er z. B. mit Aluminium beschichtet wurde, jederzeit ausgewechselt werden kann.

In vorteilhafter Weise ist dabei der tellerförmige Maskenteil 60 konzentrisch zur Längsmittelachse 58 und zum Kühlgehäuse 61 angeordnet.

Das Kühlgehäuse 61 kann ebenfalls mit dem Mittelmaskenführungsteil 56 lösbar verbunden sein.

Ebenfalls ist es möglich, daß die Außenmaske 4 mit der Kammerwand 70 lösbar verbunden ist.

Ferner ist es auch vorteilhaft, den Auslegerarm 63, den Mittelmaskenführungsteil 56, das Kühlgehäuse 61, die Membrane 59 mit ihren Klemmvorrichtungen 67, 68, die Halterung 84 sowie die beiden Drehsäulen 15 als vormontierbare Baugruppe auszubilden, die über die Schraube 87 mit dem Joch 5 lösbar verbunden ist. Hierdurch besteht die Möglichkeit, eine horizontale Verstellung gegenüber dem Joch 5 vorzunehmen, nachdem die Schraube 87 gelockert und die Konzentrizität von Mittel- und Außenmaske erreicht worden ist. Hierdurch wird die Mittelachse 58 der Membrane 59 mit Bezug auf die Mittelachse der Baugruppe stets konstant gehalten, da die Membrane 59 in die Baugruppe integriert ist.

## Patentansprüche

1. Vorrichtung zum Maskieren oder Abdecken von Substraten (27) für eine Zerstäubungskathode (2) mit einem Mittelmaskenführungsteil (56), an dem eine das Substrat (27) abdeckende Mittelmaske (26) angeordnet ist, die mit einer Außenmaske (4) derart zusammenwirkt, daß beim Beschichtungsvorgang nur der nicht abgedeckte Teil (57) des Substrats (27) beschichtet wird, **dadurch gekennzeichnet, daß** die Mittel- und/oder die Außenmaske (26 bz.w. 4) unabhängig voneinander verstellbar sind.

2. Vorrichtung nach Anspruch 1, **dadurch gekennzeichnet, daß** die Mittelmaske (26) unabhängig von der Außenmaske (4) in Abhängigkeit des Gasdrucks in der Vorrichtung zum Beschichten des Substrats (27) verstellbar ist.

3. Vorrichtung nach Anspruch 1 oder 2, **dadurch gekennzeichnet, daß** die Mittelmaske (26) unabhängig von der Außenmaske (4) in Abhängigkeit eines Differenzdrucks in der Vorrichtung in Richtung des Substrats (27) und/oder in Richtung der Längsmittelachse (58) der Vorrichtung (1) bzw. der Kathode (2) verstellbar ist.

4. Vorrichtung nach Anspruch 1, **dadurch gekennzeichnet, daß** die Differenzdruckkraft F_{dif} in der Vorrichtung durch den Außendurchmesser des verstellbaren Teils der Halterung, die koaxial zur Längsmittelachse der Kathode (58) angeordnet ist, bestimmt wird.

5. Vorrichtung nach einem oder mehreren der vorhergehenden Ansprüche, **dadurch gekennzeichnet, daß** der Differenzdruck-Durchmesser P_{d} sich im Bereich einer Membrane (59) befindet bzw. durch den Durchmesser der Membrane bestimmt wird, die die Vakuumkammer (54) der Vorrichtung gegenüber dem Raum abdichtet, in dem Atmosphärendruck herrscht.

6. Vorrichtung nach Anspruch 1, **dadurch gekennzeichnet, daß** die Mittelmaske (26) aus einem tellerförmigen Maskenteil (60) besteht, der an einem zylinderförmigen Kühlgehäuse (61) angeordnet ist, das an dem Mittelmaskenführungsteil (56) bzw. an einem Auslegerarm angeordnet und mit diesem gegenüber dem Differenzdruck verstellbar ist.

7. Vorrichtung nach einem oder mehreren der vorhergehenden Ansprüche, **dadurch gekennzeichnet, daß** der tellerförmige Maskenteil (60) abhängig oder unabhängig vom Stellweg des Auslegers zwischen zwei verstellbaren Anschlägen verstellbar ist.

8. Vorrichtung nach einem oder mehrereh der vorhergehenden Ansprüche, **dadurch gekennzeichnet, daß** der tellerförmige Maskenteil (60) lösbar mit dem zylinderförmigen Gehäuse bzw. Kühlgehäuse (61) verbunden ist.

9. Vorrichtung nach einem oder mehreren der vorhergehenden Ansprüche, **dadurch gekennzeichnet, daß** der tellerförmige, zur Längsmittelachse (58) konzentrisch angeordnete Maskenteil (60) koaxial am Kühlgehäuse (61) lösbar angeschlossen ist.

10. Vorrichtung nach einem oder mehreren der vorhergehenden Ansprüche, **dadurch gekennzeichnet, daß** das Kühlgehäuse (61) am Mittelmaskenführungsteil (56) lösbar angeschlossen und in seiner Stellbewegung durch mindestens einen Anschlag (62) begrenzbar ist.

11. Vorrichtung nach einem oder mehreren der vorhergehenden Ansprüche, **dadurch gekennzeichnet, daß** der Mittelmaskenführungsteil (56) zwischen zwei Anschlägen (62 und 63) verstellbar ist.

12. Vorrichtung nach einem oder mehreren der vorhergehenden Ansprüche, **dadurch gekennzeichnet, daß** die Anschläge (62 und 63) einstellbar sind.

13. Vorrichtung nach einem oder mehreren der vorhergehenden Ansprüche, **dadurch gekennzeichnet, daß** die Anschläge (62, 63) an dem Mittelmaskenführungsteil (56) bzw. an einem den Mittelmaskenführungsteil (56) aufnehmenden Auslegerarm (63) angeordnet sind.

14. Vorrichtung nach einem oder mehreren der vorhergehenden Ansprüche, **dadurch gekennzeichnet, daß** die Membrane (59), das Kühlgehäuse (61) und/oder die Mittelmaske (26) den den Atmosphärendruck Pₐ aufweisenden Raum (55) gegenüber dem den Vakuumdruck aufweisenden Raum bzw. der Vakuumkammer (54) abdichten.

15. Vorrichtung nach einem oder mehreren der vorhergehenden Ansprüche, **dadurch gekennzeichnet, daß** die Membrane (59) aus einem zylinderförmigen Teil bzw. Mittelstück (64) besteht, an das endseitig je ein Flansch (65, 66) angeschlossen ist, der in je einer Klemmvorrichtung (67, 68) derart lösbar aufgenommen ist, daß die Mittelmaske (26) gegenüber der Klemmvorrichtung bzw. gegenüber den nicht verstellbaren Teilen der Vorrichtung bzw. der Außenmaske (4) verstellbar ist.

16. Vorrichtung nach einem oder mehreren der vorhergehenden Ansprüche, **dadurch gekennzeichnet, daß** die Mittelmaske (26) mit Bezug auf die Außenmaske (4) in der Anfangsstellung, in der die Masken mit Abstand zur Oberfläche des Substrats (27) angeordnet sind, gegenüber der Oberfläche der Außenmaske (4) derart hervorsteht, daß die Mittelmaske erst gegen die Oberfläche des Substrats (27) zur Anlage kommt, wenn es in Richtung der Mittelmaske (26) bewegt wird.

17. Vorrichtung nach einem oder mehreren der vorhergehenden Ansprüche, **dadurch gekennzeichnet, daß** die Außenmaske (4) und/oder der untere Teil (26') der Mittelmaske (26) lösbar angeschlossen sind.

18. Vorrichtung nach einem oder mehreren der vorhergehenden Ansprüche, **dadurch gekennzeichnet, daß** die Außenmaske (4) und/oder der untere Teil (26') der Mittelmaske (26) mit annähernd gleichem Anpreßdruck gegen die Oberfläche des Substrats (27) zur Anlage kommen.

19. Vorrichtung nach einem oder mehreren der vorhergehenden Ansprüche, **dadurch gekennzeichnet, daß** der Mittelmaskenführungsteil (56), der Auslegerarm (63) bzw. der den Mittelmaskenführungsteil (56) führende bzw. verstellende Teil in einem ständig Atmosphärendruck Pₐ aufweisenden Raum vorgesehen sind.

## Claims

1. A device for masking or covering substrates (27) for a sputtering cathode (2) comprising a center mask guide element (56) to which a center mask (26) covering the substrate (27) is attached, said center mask (26) cooperating with an outer mask (4) in such a way that during the sputtering operation only the non-covered part (57) of the substrate (27) is coated, **characterized in that** the center and/or the outer masks (26 and/or 4, respectively) can be displaced independent of one another.

2. The device according to claim 1, **characterized in that** the center mask (26) can be adjusted independently of the outer mask (4) as a function of the gas pressure in said device for coating the substrate (27).

3. The device according the claim 1 or 2, **characterized in that** the center mask (26) can be adjusted independently of the outer mask (4) as a function of a differential pressure in the device in the direction to the substrate (27) and/or in the direction to the longitudinal center axis (58) of the device (1) or the cathode (2).

4. The device according to claim 1, **characterized in that** the differential pressure force F_{dif} in the device is determined by the outer diameter of the adjustable portion of the holder which is arranged coaxially with the longitudinal center axis of the cathode (58).

5. The device according to one or a plurality of the preceding claims, **characterized in that** the differential pressure diameter P_{d} is situated in the area of a diaphragm (59) or is determined by the diameter of the diaphragm which seals the vacuum chamber (54) of the device against the space in which atmospheric pressure prevails.

6. The device according to claim 1, **characterized in that** the center mask (26) consists of a plate-shaped mask element (60) which is disposed on a cylinder-shaped cooling housing (61), the latter being arranged on the center mask guide element (56) or a cantilever arm and being adjustable by means of the latter in relation to the differential pressure.

7. The device according to one or a plurality of the preceding claims, **characterized in that** the plate-shaped mask element (60) can be adjusted between two adjustable stops dependently or independently of the adjustment path of the cantilever.

8. The device according to one or a plurality of the preceding claims, **characterized in that** the plate-shaped mask element (60) is releasably connected with the cylinder-shaped housing or cooling housing (61).

9. The device according to one or a plurality of the preceding claims, **characterized in that** the plate-shaped mask element (60), which is disposed concentrically with the longitudinal center axis (58), is coaxially releasably connected to the cooling housing (61).

10. The device according to one or a plurality of the preceding claims, **characterized in that** the cooling housing (61) is releasably connected to the center mask guide element (56) and its adjusting movement can be limited by at least one stop (62).

11. The device according to one or a plurality of the preceding claims, **characterized in that** the center mask guide element (56) can be adjusted between two stops (62 and 63).

12. The device according to one or a plurality of the preceding claims, **characterized in that** the stops (62 and 63) are adjustable.

13. The device according to one or a plurality of the preceding claims, **characterized in that** the stops (62, 63) are disposed on the center mask guide element (56) or on a cantilever arm (63) which receives the center mask guide element (56).

14. The device according to one or a plurality of the preceding claims, **characterized in that** the diaphragm (59), the cooling housing (61) and/or the center mask (26) seal the chamber (55) with atmospheric pressure Pₐ in respect to the chamber with the vacuum pressure or the vacuum chamber (54).

15. The device according to one or a plurality of the preceding claims, **characterized in that** the diaphragm (59) consists of a cylinder-shaped element or center piece (64), the ends of which being respectively connected to one flange (65, 66) each which is releasably received in respectively one clamping device (67, 68) so that the center mask (26) can be adjusted in relation to the clamping device or the nonadjustable elements of the device or the outer mask (4).

16. The device according to one or a plurality of the preceding claims, **characterized in that** in the initial position, in which the masks are spaced from the surface of the substrate (27), the center mask (26), with respect to the outer mask (4), protrudes in respect to the surface of the outer mask (4) in such a way that the center mask first abuts the surface of the substrate (27) when the latter is moved in the direction toward the center mask (26).

17. The device according to one or a plurality of the preceding claims, **characterized in that** the outer mask (4) and/or the lower part (26') of the center mask (26) are releasably connected.

18. The device according to one or a plurality of the preceding claims, **characterized in that** the outer mask (4) and/or the lower part (26') of the center mask (26) abut the surface of the substrate (27) with approximately the same contact pressure.

19. The device according to one or a plurality of the preceding claims, **characterized in that** the center mask guide element (56), the cantilever arm (63) or the element which guides or adjusts the center mask guide element (56) are provided in a space which is continuously under an atmospheric pressure Pₐ.

## Revendications

1. Dispositif de masquage, ou recouvrement, de substrats (27), destiné à une cathode de pulvérisation (2) comportant une pièce de guidage (56) de masque médian, sur laquelle est disposé un masque médian (26) recouvrant le substrat (27), qui coopère avec un masque extérieur (4) de façon telle que, lors du processus de revêtement, seule la partie non recouverte (57) du substrat (27) est revêtue, **caractérisé en ce que** le masque médian et/ou le masque extérieur (26 et/ou 4) peuvent être positionnés indépendamment l'un de l'autre.

2. Dispositif selon la revendication 1, **caractérisé en ce que** le masque médian (26) peut être positionné indépendamment du masque extérieur (4), en fonction de la pression de gaz dans le dispositif destiné au revêtement du substrat (27).

3. Dispositif selon la revendication 1 ou 2, **caractérisé en ce que** le masque médian (26) peut être positionné indépendamment du masque extérieur (4), en fonction d'une pression différentielle dans le dispositif en direction du substrat (27) et/ou en direction de l'axe longitudinal/médian (58) du dispositif (1), ou de la cathode (2).

4. Dispositif selon la revendication 1, **caractérisé en ce que** la force de pression différentielle F_{dif} est déterminée, dans le dispositif, par le diamètre extérieur de la partie réglable du support qui est disposée coaxialement à l'axe longitudinal médian de la cathode (58).

5. Dispositif selon une ou plusieurs des revendications qui précèdent, **caractérisé en ce que** le diamètre de pression différentielle P_{d} se trouve dans la zone d'une membrane (59), ou est déterminé par le diamètre de la membrane qui rend l'enceinte sous vide (54) du dispositif étanche par rapport à l'espace dans lequel règne la pression atmosphérique.

6. Dispositif selon la revendication 1, **caractérisé en ce que** le masque médian (26) est constitué par une pièce de masque (60) en forme de disque, qui est disposée sur un corps de refroidissement (61) de forme cylindrique qui est mis en place sur la pièce de guidage (56) de masque médian, ou sur un bras en porte-à-faux, et **en ce qu'**il peut être positionné au moyen de celle-ci en fonction de la pression différentielle.

7. Dispositif selon une ou plusieurs des revendications qui précèdent, **caractérisé en ce que** la pièce de masque (60) en forme de disque peut être positionnée entre deux butées réglables en fonction de la course de positionnement du bras en porte-à-faux ou indépendamment de celle-ci.

8. Dispositif selon une ou plusieurs des revendications qui précèdent, **caractérisé en ce que** la pièce de masque (60) en forme de disque est reliée de façon libérable au corps de forme cylindrique, ou corps de refroidissement (61).

9. Dispositif selon une ou plusieurs des revendications qui précèdent, **caractérisé en ce que** la pièce de masque (60) en forme de disque et disposée concentriquement à l'axe longitudinal médian (58) est reliée coaxialement au corps de refroidissement (61), de façon libérable.

10. Dispositif selon une ou plusieurs des revendications qui précèdent, **caractérisé en ce que** le corps de refroidissement (61) est relié de façon libérable à la pièce de guidage (56) de masque médian et qu'il peut être limité dans son déplacement de positionnement par au moins une butée (62).

11. Dispositif selon une ou plusieurs des revendications qui précèdent, **caractérisé en ce que** la pièce de guidage (56) de masque médian peut être positionnée entre deux butées (62 et 63).

12. Dispositif selon une ou plusieurs des revendications qui précèdent, **caractérisé en ce que** les butées (62 et 63) sont réglables.

13. Dispositif selon une ou plusieurs des revendications qui précèdent, **caractérisé en ce que** les butées (62, 63) sont disposées sur la pièce de guidage (56) de masque médian ou sur un bras en porte-à-faux (63) recevant la pièce de guidage (56) de masque médian.

14. Dispositif selon une ou plusieurs des revendications qui précèdent, **caractérisé en ce que** la membrane (59), le corps de refroidissement (61) et/ou le masque médian (26) rendent l'espace (55), soumis à la pression atmosphérique Pₐ, étanche par rapport à l'espace sous vide, ou à l'enceinte sous vide (54).

15. Dispositif selon une ou plusieurs des revendications qui précèdent, **caractérisé en ce que** la membrane (59) est constituée par une pièce cylindrique, ou pièce médiane, (64), à chacune des extrémités de laquelle se raccorde un collet (65, 66), chacun des collets étant reçu dans un dispositif de serrage (67, 68) de façon libérable de telle sorte que le masque médian (26) peut être positionné par rapport au dispositif de serrage, ou par rapport aux pièces non réglables du dispositif, ou au masque extérieur (4).

16. Dispositif selon une ou plusieurs des revendications qui précèdent, **caractérisé en ce que** le masque médian (26) en relation avec le masque extérieur (4) dans la position de départ, dans. laquelle les masques sont disposés avec un écart par rapport à la surface du substrat (27) fait saillie par rapport à la surface du masque extérieur (4) de façon telle que le masque médian ne vient en appui contre la surface du substrat (27) que lorsque le substrat est déplacé en direction du masque médian (26).

17. Dispositif selon une ou plusieurs des revendications qui précèdent, **caractérisé en ce que** le masque extérieur (4) et/ou la partie inférieure (26') du masque médian (26) sont reliés de façon libérable.

18. Dispositif selon une ou plusieurs des revendications qui précèdent, **caractérisé en ce que** le masque extérieur (4) et/ou la partie inférieure (26') du masque médian (26) viennent en appui, avec approximativement la même pression d'appui, contre la surface du substrat (27).

19. Dispositif selon une ou plusieurs des revendications qui précèdent, **caractérisé en ce que** la pièce de guidage (56) du masque médian, le bras en porte-à-faux (63) ou la pièce guidant ou positionnant la pièce de guidage (56) du masque médian sont prévus dans un espace dans lequel règne en permanence la pression atmosphérique Pₐ.
